# EUROPEAN PATENT SPECIFICATION

(11) **EP 4 046 062 B1**
(45) Date of publication and mention of the grant of the patent: **18.03.2026**
(21) Application number: 20803706.9
(22) Date of filing: 15.10.2020
(51) Int. Cl.: G06V 10/764, G06V 10/82, G06V 20/10

(54) **SYSTEMS FOR THE CLASSIFICATION OF INTERIOR STRUCTURE AREAS BASED ON EXTERIOR IMAGES**
SYSTEME ZUR KLASSIFIZIERUNG VON INNENRAUMSTRUKTUREN ANHAND VON AUSSENBILDERN
SYSTÈMES DE CLASSIFICATION DES ZONES DE STRUCTURES INTÉRIEURES SUR LA BASE D'IMAGES EXTÉRIEURES

(30) Priority: 18.10.2019 US 201962923165 P
(43) Date of publication of application: 24.08.2022
(73) Proprietor: Pictometry International Corp., Rochester, NY 14623 (US)
(72) Inventor: STRONG, Shadrian, Bellevue, WA 98004 (US)
(74) Representative: Murgitroyd & Company
(86) International application number: PCT/US2020/055771
(87) International publication number: WO 2021/076747

(56) References cited:
- CHU HANG ET AL: "HouseCraft: Building Houses from Rental Ads and Street Views", 17 September 2016, ISSN: 0302-9743, XP047565734
- KANG JIAN ET AL: "Building instance classification using street view images", ISPRS JOURNAL OF PHOTOGRAMMETRY AND REMOTE SENSING, AMSTERDAM [U.A.] : ELSEVIER, AMSTERDAM, NL, vol. 145, 2 March 2018 (2018-03-02), pages 44 - 59, XP085499061, ISSN: 0924-2716, DOI: 10.1016/J.ISPRSJPRS.2018.02.006

## Description

### Cross-Reference to Related Applications

This application claims priority to the provisional patent application identified by U.S. Serial No. 62/923,165, filed October 18, 2019, titled "SYSTEMS FOR THE CLASSIFICATION OF INTERIOR STRUCTURE AREAS BASED ON EXTERIOR IMAGES".

### Background

Determining the livable area of a structure often requires an inspector traveling to the structure and taking measurements. This process is slow and expensive due to the limited number of inspectors and the time required to travel and manually measure interior spaces. Additionally, approval from and scheduling time with owners in order to access building interiors can be time consuming and problematic. These inefficiencies may cause extended periods of time between inspections for any specific structure resulting in outdated or incomplete data being used for structure assessment.

Currently, analyses can be carried out on images depicting buildings exteriors to determine total exterior footprints of the buildings in the images. However, footprints do not reveal floorplan area information or a measure of living area.

What is needed are systems and methods to determine livable areas, and/or how areas are utilized, of a structure from digital imagery of exterior surfaces of the structure, in which the process is not as time consuming or as expensive as the manual process of manually measuring interiors at the building site, but is more accurate and provides more information about a structure than general image observations or footprint determinations.
CHU HANG ET AL "HouseCraft: Building Houses from Rental Ads and Street Views": 17 September 2016 (2016-09-7), ISSN: 0302-9743, relates to creating building exterior models using existing street view images and existing floor plans.

### Summary

The problems in automating the determination of livable areas of a structure are solved with the systems and methods described herein. In general, the present disclosure describes an interior area classification system that can be a fully automated, machine learning solution for extraction of different types of areas (e.g., total area, total living area) within a structure (e.g., building) using images of the exterior surfaces of the structure. In some implementations, this can be accomplished by analyzing one or more digital image of the structure with an exterior surface feature segmentation model.

The structure has an exterior surface with a plurality of exterior features. Each of the exterior features may have at least one feature classification of an interior of the structure. The feature classifications may include livable and non-livable.

The exterior surface depicted in each of the one or more images may be processed into a plurality of exterior feature segments with the exterior surface feature segmentation model. The exterior feature segment(s) may correspond to at least one exterior feature. The plurality of exterior feature segments may be projected into a coordinate system based at least in part on image metadata associated with the digital images of the structure. The projected exterior feature segments may form a structure model.

The exterior surface(s) depicted in the one or more digital image may be processed with a structure level determination model to determine a number of stories of the structure. The structure model may be updated to include the number of stories. A segmented classification map of the interior of the structure may be generated by, for example, fitting one or more geometric section into the structure model in a position and orientation based at least in part on the plurality of exterior feature segments.

Each of the one or more geometric sections has a length, a width, and an area. The total living area, for example, may be calculated by summing the area of each of the one or more geometric section corresponding to exterior features with at least one feature classification of livable. An adjusted living area may be calculated by summing the areas of all of the geometric sections.

Thus, the interior area classification system of the present disclosure may estimate internal structural information of the structure using exterior images. The interior area classification system may be automated, at scale, by analyzing a variety of buildings individually using exterior images.

Further, in one embodiment, the system may infer information about the interior structure of structures based exclusively on external digital images. The external digital images may be acquired at large scale, for example, with aerial imaging systems. The external digital images may have high resolutions.

In some implementations, rather than extracting the exterior structure of the building as a whole, the system may determine how different sections of buildings are utilized, for example, as living areas, garages, porches, decks, patios, etc. Being able to characterize interiors of buildings from digital images of exteriors of structure, in a scalable manner, is a significant improvement upon the current state of the art.

### Brief Description of Several Views of the Drawings

The accompanying drawings, which are incorporated in and constitute a part of this specification, illustrate one or more implementations described herein and, together with the description, explain these implementations. The drawings are not intended to be drawn to scale, and certain features and certain views of the figures may be shown exaggerated, to scale or in schematic in the interest of clarity and conciseness. Not every component may be labeled in every drawing. Like reference numerals in the figures may represent and refer to the same or similar element or function. In the drawings:
FIG. 1 is a schematic of an exemplary embodiment of an interior area classification system in accordance with the present disclosure.
FIG. 2 is an exemplary computer system in accordance with the present disclosure.
FIG. 3 is an exemplary embodiment of an image analysis module in accordance with the present disclosure.
FIG. 4A is an exemplary oblique image depicting a structure of interest in accordance with the present disclosure.
FIG. 4B is an exemplary nadir image depicting the structure of interest of Figure 3A in accordance with the present disclosure.
FIG. 5A is an exemplary depiction of image segments depicted in the image of Figure 3A in accordance with the present disclosure.
FIG. 5B is an exemplary depiction of image segments depicted in the image of Figure 3B in accordance with the present disclosure.
FIG. 6 is an exemplary depiction of the image segments of Figure 4A and Figure 4B projected onto a coordinate system in accordance with the present disclosure.
FIG. 7 is an exemplary depiction of additional image segments projected onto the coordinate system in accordance with the present disclosure.
FIG. 8 is an exemplary nadir image of the structure of interest with all image segments projected onto the structure depicted in the nadir image of Figure 3B.
FIG. 9 is an exemplary embodiment of geographic figures placed onto the nadir image of the structure depicted in the image of Figure 3B.
FIG. 10 is a process flow diagram of an exemplary embodiment of an interior area classification method in accordance with the present disclosure.

### Detailed Description

Before explaining at least one embodiment of the disclosure in detail, it is to be understood that the disclosure is not limited in its application to the details of construction, experiments, exemplary data, and/or the arrangement of the components set forth in the following description or illustrated in the drawings unless otherwise noted.

The disclosure is capable of other embodiments or of being practiced or carried out in various ways. For instance, although extent change of a residential building structure may be used as an example, the methods and systems may be used to assess other characteristics (by way of example and not limited to, changes in structure footprint or structure area) of other man-made objects, non-exclusive examples of which include other types of buildings such as industrial buildings, or commercial buildings. Also, it is to be understood that the phraseology and terminology employed herein is for purposes of description, and should not be regarded as limiting.

As used in the description herein, the terms "comprises," "comprising," "includes," "including," "has," "having," or any other variations thereof, are intended to cover a non-exclusive inclusion. For example, unless otherwise noted, a process, method, article, or apparatus that comprises a list of elements is not necessarily limited to only those elements, but may also include other elements not expressly listed or inherent to such process, method, article, or apparatus.

Further, unless expressly stated to the contrary, "or" refers to an inclusive and not to an exclusive "or". For example, a condition A or B is satisfied by one of the following: A is true (or present) and B is false (or not present), A is false (or not present) and B is true (or present), and both A and B are true (or present).

In addition, use of the "a" or "an" are employed to describe elements and components of the embodiments herein. This is done merely for convenience and to give a general sense of the inventive concept. This description should be read to include one or more, and the singular also includes the plural unless it is obvious that it is meant otherwise. Further, use of the term "plurality" is meant to convey "more than one" unless expressly stated to the contrary.

As used herein, qualifiers like "substantially," "about," "approximately," and combinations and variations thereof, are intended to include not only the exact amount or value that they qualify, but also some slight deviations therefrom, which may be due to computing tolerances, computing error, manufacturing tolerances, measurement error, wear and tear, stresses exerted on various parts, and combinations thereof, for example.

As used herein, any reference to "one embodiment," "an embodiment," "some embodiments," "one example," "for example," or "an example" means that a particular element, feature, structure or characteristic described in connection with the embodiment is included in at least one embodiment and may be used in conjunction with other embodiments. The appearance of the phrase "in some embodiments" or "one example" in various places in the specification is not necessarily all referring to the same embodiment, for example.

The use of ordinal number terminology (i.e., "first", "second", "third", "fourth", etc.) is solely for the purpose of differentiating between two or more items and, unless explicitly stated otherwise, is not meant to imply any sequence or order or importance to one item over another or any order of addition.

The use of the term "at least one" or "one or more" will be understood to include one as well as any quantity more than one. In addition, the use of the phrase "at least one of X, V, and Z" will be understood to include X alone, V alone, and Z alone, as well as any combination of X, V, and Z.

The term "component," may include hardware, such as a processor (e.g., microprocessor), an application specific integrated circuit (ASIC), field programmable gate array (FPGA), a combination of hardware and software, and/or the like. The term "processor" as used herein means a single processor or multiple processors working independently or together to collectively perform a task.

Software includes one or more computer readable instructions, also referred to as executable code, that when executed by one or more components cause the component to perform a specified function. It should be understood that the algorithms described herein may be stored on one or more non-transitory computer readable medium.

Exemplary non-transitory computer readable mediums include random access memory, read only memory, flash memory, and/or the like. Such non-transitory computer readable mediums may be electrically based, magnetically based, optically based, and/or the like. Non-transitory computer readable medium may be referred to herein as non-transitory memory.

Total living area is generally defined as the area of a building that is air-controlled. Specific types of air-controlling systems may vary and depend upon climate and the location of the building. Exemplary types of air-controlling systems include at least one of a heating system and/or a cooling system that control the temperature and/or humidity and/or movement of the air in the area. In some implementations, total living area may be defined as the areas of a building that are habitable. The total living area and sub-sections of the total living area may be referred to herein as livable area(s) and/or livable.

Non-livable areas are defined as areas not air-controlled and/or habitable, which may include (but are not limited to) porches, carports, utility areas, garages, some sunrooms, covered walkways, verandas, lean-tos, etc. The total non-livable area and sub-sections (e.g., porches, carports, utility areas, garages, some sunrooms, covered walkways, verandas, lean-tos, etc.) of the total non-livable area may be referred to herein as non-living area(s) and/or non-livable and/or non-livable area(s).

Adjusted living area is defined as the total living area plus non-livable areas.

Building area may be defined as the area of a building under a permanent roof.

Digital images can be described as pixelated arrays of electronic signals. The array may include three dimensions. Such an array may include spatial (x, y or latitude, longitude) and spectral (e.g. red, green, blue) elements. Each pixel in the image captures wavelengths of light incident on the pixel, limited by the spectral bandpass of the system. The wavelengths of light are converted into digital signals readable by a computer as float or integer values. How much signal exists per pixel depends, for example, on the lighting conditions (light reflection or scattering), what is being imaged, and even the imaged object's chemical properties.

Machine Learning (ML) is generally the scientific study of algorithms and statistical models that computer systems use in order to perform a specific task effectively without using explicit instructions, relying on patterns and inference instead. It is considered a subset of artificial intelligence (Al). Machine learning algorithms build a mathematical model based on sample data, known as "training data", in order to make predictions or decisions without being explicitly programmed to perform the task. Machine learning algorithms may be used in applications, such as digital imagery analysis, where it is infeasible to develop an algorithm of specific instructions for performing one or more task. Machine Learning algorithms are commonly in the form of an artificial neural network (ANN), also called a neural network (NN). A neural network "learns" to perform tasks by considering examples, generally without being programmed with any task-specific rules. The examples used to teach a neural network may be in the form of truth pairings comprising a test input object and a truth value that represents the true result from the test input object analysis. When a neural network has multiple layers between the input and the output layers, it may be referred to as a deep neural network (DNN).

For machine learning with digital imagery, a computer system may be trained to deconstruct digital images into clusters of aggregated pixels and statistically identify correlations in the clusters. The correlations are iteratively evaluated and "learned" from by the computer system, based on a directive to classify a set of patterns as a specific thing. For example, the directive could be to classify the set of patterns to distinguish between a cat and dog, identify all the cars, find the damage on the roof of a building, and so on. The utilization of neural networks in machine learning is known as deep learning.

Over many imaged objects, regardless of color, orientation, or size of the object in the digital image, these specific patterns for the object are mostly consistent-in effect they describe the fundamental structure of the object of interest. For an example in which the object is a cat, the computer system comes to recognize a cat in an image because the system understands the variation in species, color, size, and orientation of cats after seeing many images or instances of cats. The learned statistical correlations are then applied to new data to extract the relevant objects of interest or information.

Convolutional neural networks (CNN) are machine learning models that may be used to perform this function through the interconnection of equations that aggregate the pixel digital numbers using specific combinations of connections of the equations and clustering the pixels, in order to statistically identify objects (or "classes") in a digital image. Exemplary uses of Convolutional Neural Networks are explained, for example, in "ImageNet Classification with Deep Convolutional Neural Networks," by Krizhevsky et al. (Advances in Neural Information Processing Systems 25, pages 1097-1105, 2012); and in "Fully Convolutional Networks for Semantic Segmentation," by Long et al. (IEEE Conference on Computer Vision and Pattern Recognition, June 2015.

Generative adversarial networks (GANs) are neural network deep learning architectures comprising two neural networks and pitting one against the other. One neural network, called a Generator, generates new data instances, while another neural network, called a Discriminator, evaluates the new data instances for authenticity, that is, the Discriminator decides whether each data instance belongs to the training data set or not. The creation of a generative adversarial network is explained, for example, in "Generative Adversarial Networks," by Goodfellow, et al (Departement d'informatique et de recherche operationnelle Universite de Montreal, June 2014).

When using computer-based supervised deep learning techniques, such as with a CNN, for digital images, a user provides a series of examples of digital images of the objects of interest to the computer and the computer system uses a network of equations to "learn" significant correlations for the object of interest via statistical iterations of pixel clustering, filtering, and convolving.

The artificial intelligence/neural network output is a similar type model, but with greater adaptability to both identify context and respond to changes in imagery parameters. It is typically a binary output, formatted and dictated by the language/format of the network used, that may then be implemented in a separate workflow and applied for predictive classification to the broader area of interest. The relationships between the layers of the neural network, such as that described in the binary output, may be referred to as the neural network model or the machine learning model.

In the technological field of remote sensing, digital images may be used for mapping geospatial information. Classifying pixels in an image for geospatial information purposes has been done through various techniques. For example, some CNN-based techniques include Semantic Segmentation (also known as pixel-wise classification or individual pixel mapping) using fully convolutional neural networks (FCN) as described in "Fully Convolutional Networks for Semantic Segmentation," by Long et al., referenced above. In this technique, each pixel in the image is given a label or classification based on training data examples, as discussed in the general overview above. However, the technique is computationally intensive, as it requires resources of computational space, time, and money to assess each individual pixel.

A technique that exists outside of the technological field of geospatial mapping is General Image Classification using a convolutional neural network (CNN), such as that described by Simonyan et al. in the article "Very Deep Convolutional Networks for Large-Scale Image Recognition" (International Conference on Machine Learning, 2015). In General Image Classification, rather than individual pixels being labeled, an entire image is given a generalized label. This is typically a much simpler algorithm than the FCN Semantic Segmentation, and so may require less computation. However, this method provides less information about an image, as it is limited to the image as an aggregated whole as a generalization rather than identifying particulars, such as where objects in the scene are located within the digital image or where particular information is located within the digital image.

Described below are examples of a fully automated machine learning solution for extraction of interior information such as total living area, adjusted living area, building area, and/or further interior area classifications, from digital imagery of exteriors of a structure, in a quantifiable manner.

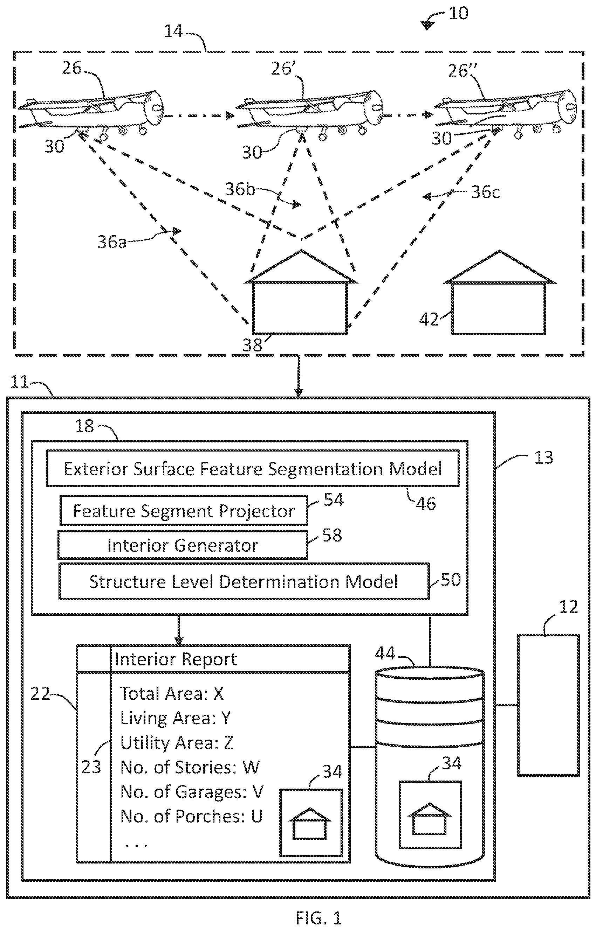

Referring now to the drawings, FIG. 1 is a schematic of an exemplary embodiment of an interior area classification system 10. The interior area classification system 10 may comprise a computer system 11 comprising one or more computer processors 12 and one or more non-transitory memory 13 storing an image analysis module 18 configured to analyze digital images 34 of exteriors of target structures 38 and a report generation module 22 configured to generate one or more report 23 describing the interior area of the target structure when executed by the one or more computer processors 12.

In some implementations, the interior area classification system 10 may further comprise an image capture system 14 to capture the digital images 34 (e.g., one or more ortho and/or oblique images acquired from overhead or on the ground) of the exterior(s) of one or more target structure 38. In some embodiments, the image capture system 14, the image analysis module 18, and the report generation module 22 operate substantially simultaneously, while in other embodiments, the image capture system 14 operates prior to and/or independent of the image analysis module 18 and/or the report generation module 22. In some implementations, the image analysis module 18 receives or obtains the digital images 34 from an outside source instead of, or in addition to, the image capture system 14.

In some implementations, the image analysis module 18 and the report generation module 22 are implemented as software (also known as executable code) that is stored on the one or more non-transitory memory 13 and that, when executed by the one or more computer processors 12, cause the one or more computer processors 12 to carry out one or more actions. In some implementations, the image analysis module 18 may change the functionality of the one or more computer processors 12.

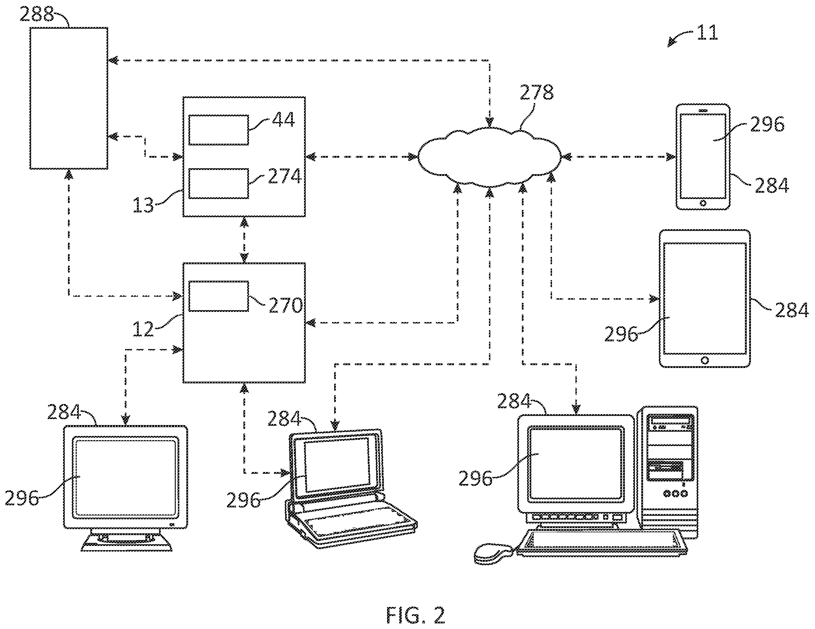

As shown in FIG. 2, the one or more computer processor 12 may include (or be communicatively coupled with) one or more communication component 270. The one or more non-transitory memory 13 may store one or more database, such as an image database 44 and/or a segmented image database 274. The image database 44 and the segmented image database 274 may be separate databases, or may be integrated into a single database and may be stored in one or more, or in two or more, non-transitory memory 13.

In some implementations, the computer system 11 may include a network 278 enabling bidirectional communication between the one or more computer processors 12 and/or the one or more non-transitory memory 13 with a plurality of user devices 284. The user devices 284 may communicate via the network 278 and/or may display information on a screen 296. In some implementations, the one or more computer processors 12 are two or more computer processors 12, in which case, the two or more computer processors 12 may or may not necessarily be located in a single physical location.

In one embodiment, the network 278 is the Internet and the user devices 284 interface with the one or more computer processor 12 via the communication component 270 using a series of web pages. It should be noted, however, that the network 278 may be almost any type of network and may be implemented as the World Wide Web (or Internet), a local area network (LAN), a wide area network (WAN), a metropolitan network, a wireless network, a cellular network, a Global System for Mobile Communications (GSM) network, a code division multiple access (CDMA) network, a 3G network, a 4G network, a 5G network, a satellite network, a radio network, an optical network, a cable network, an Ethernet network, combinations thereof, and/or the like. It is conceivable that in the near future, embodiments of the present disclosure may use more advanced networking topologies.

In one embodiment, the one or more computer processor 12 and the one or more non-transitory memory 13 may be implemented with a server system 288 having multiple servers in a configuration suitable to provide a commercial computer-based business system such as a commercial web-site and/or data center.

Returning again to FIG. 1, in one embodiment, the image capture system 14 may comprise one or more capture platform 26 and one or more camera 30 connected to, attached to, within, and/or integrated with the capture platform 26. The camera 30 may capture the one or more digital image 34 of an exterior of a structure 38 at one or more positions at one or more instances of time with one or more camera 30.

For explanatory purposes, FIG. 1 shows the capture platform 26 at a first position at a first instance in time capturing with the camera 30 a first oblique digital image 34 using a first field of view 36a, as well as the capture platform 26 at a second position as capture platform 26' capturing with the camera 30 a nadir digital image 34a of the structure 38 using a second field of view 36b at a second instance in time, and the capture platform 26 as capture platform 26" at a third position capturing with the camera 30 a second oblique digital image 34b of the structure 38 using a third field of view 36c at a third instance in time. Though the digital images 34 are described in this example as two oblique images 34 and one nadir image 34, other combinations or oblique and nadir images may be utilized.

In some implementations, the one or more camera 30 of the capture platform 26 may capture digital images 34 of more than one structure 38 at one time. For instance, the structure 38 may be a first structure 38 and the capture platform 26' at the second instance in time may capture the first nadir digital image 34 of the first structure 38 while also capturing a first oblique image 34 of a second structure 42, and/or a single image 34 may depict both the first structure 38 and the second structure 42 within the single image 34.

Once the digital images 34 are captured, the digital images 34 may be stored in the captured image database 44. While the captured image database 44 is shown to be an element within the non-transitory memory 13 with the image analysis module 18 and the report generation module 22, it is understood that the captured image database 44 may be stored separately from one of, two of, or all of the image capture system 14, the image analysis module 18, and the report generation module 22.

In some embodiments, the capture platform 26 comprises a manned aircraft and/or an unmanned aircraft. In some embodiments, the capture platform 26 may comprise one or more vehicle, either manned or unmanned, aerial based or ground based. Exemplary vehicles include an aircraft, an airplane, a helicopter, a drone, a car, a boat, or a satellite. In some embodiments, the image capture system 14 may be carried by a person. For example, the image capture system 14 may be implemented as a portable telephone and/or a portable computer system (such as a computer tablet).

In one embodiment, the at least one camera 30 can be oriented and located in various orientations and locations, such as street view, satellite, automotive based, unmanned aerial vehicle based, and/or manned aerial vehicle based.

The digital images 34 may contain or be associated with image data. The image data may contain nominal "visible-band" (red, green, blue) wavelength spectral data or other spectral bands data (for example, infrared wavelength spectral data).

Two or more of the images 34 may be captured independently at different instances of time, and/or two or more of the images 34 may be captured simultaneously using multiple cameras 30.

In some implementations, the images 34 may be captured through the use of a global shutter in which all of the sensors within the camera 30 are exposed simultaneously, a rolling shutter in which different scanlines in the sensor are exposed at different times, or combinations thereof. In one embodiment, one or more of the images 34 may be a synthetic global shutter image created from a rolling shutter image, or combinations thereof. An exemplary synthetic global shutter image is disclosed in the patent application identified by U.S. Patent Application Serial No. 16/343,610 (Pub. No. US2020/0059601A1), entitled "An Image Synthesis System".

In one embodiment, the images 34 may have, or may be correlated with, metadata. The metadata may be indicative of one or more of the location, orientation, and camera parameters of the camera 30 at the precise moment each image 34 is captured. Nonexclusive exemplary metadata includes X, Y and Z information (e.g., latitude, longitude, and altitude; or other geographic grid coordinates); time; orientation such as pitch, roll, and yaw of the platform 26 and/or camera 30; camera parameters such as focal length and sensor size; and correction factors such as error due to calibrated focal length, sensor size, radial distortion, principal point offset, and alignment.

The digital images 34 are geo-referenced, that is processed such that pixels in the image have a determined geo-location, such as X, Y, and Z coordinates and/or latitude, longitude, and elevation / altitude coordinates. The determined geo-location, such as X, Y, and Z coordinates and/or latitude, longitude, and elevation / altitude coordinates are included within the metadata. In some implementations, the images 34 may be georeferenced using the techniques described in U.S. Patent No. 7,424,133, and/or U.S. Patent Application Serial No. 16/343,610 (Pub. No. US2020/0059601A1). The metadata may be stored within the images 34 or stored separately from the images 34 and related to the images 34 using any suitable technique, such as unique identifiers.

In one embodiment, each of the images 34 may have a unique image identifier such as by use of the metadata, or otherwise stored in such a way that allows a computer system 260 to definitively identify each of the images 34 and/or associate the images 34 with the metadata.

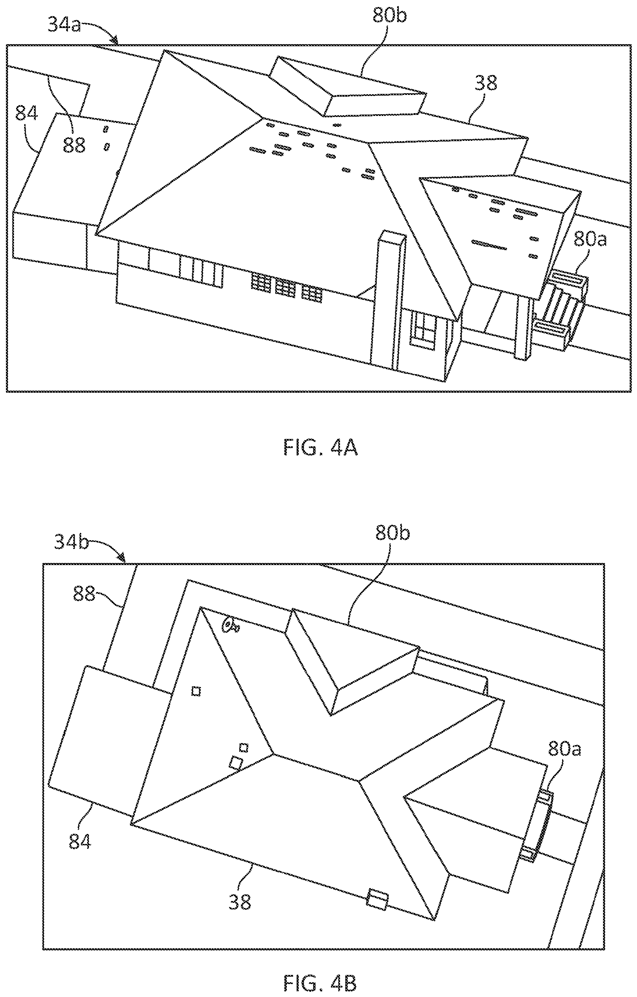

The one or more images 34 of the structure 38 may be captured by the one or more camera 30 from an aerial perspective over the structure 38 or from a ground-based perspective. With respect to an aerial perspective, the images 34 may be from a directly overhead viewpoint, also referred to as an ortho view or nadir view (as seen in the second field of view 36b in FIG. 1, for example), typically taken directly below and/or vertically downward from the camera lens positioned above the structure as shown in the resulting image 34b depicted in Figure 4B and explained in more detail below, or an aerial oblique view (as seen in the first field of view 36a and third field of view 36c in FIG. 1, for example) as shown in the resulting image 34a depicted in Figure 4A and explained in more detail below. An aerial oblique view may be taken from approximately 10 degrees to 75 degrees from a nadir direction. In one embodiment, certain of the images 34 may be nadir, and some of the images 34 may be captured from different oblique angles. For example, a first image 34 may be an aerial nadir image, a second image 34 may be an aerial oblique image taken from approximately 10 degrees from the nadir direction, and a third image 34 may be an aerial oblique image taken from approximately 20 degrees from the nadir direction.

In some embodiments, the images 34 of the structure 38 include at least one nadir image and multiple oblique images taken from various viewpoints. The various viewpoints may include, for example, one or more of an east facing viewpoint, a west facing viewpoint, a north facing viewpoint, and a south facing viewpoint. In some embodiments, the images 34 may only be oblique images taken from various viewpoints to depict the roof and the exterior walls of the structure 38.

Exemplary image capture components that can be used to capture the images 34 are disclosed in U.S. Patent No. 7,424,133, U.S. Patent No. 8,385,672, and U.S. Patent Application Publication No. 2017/0244880.

In one embodiment, a particular structure, such as the structure 38, may be selected for analysis. The selection of the structure 38 may be performed by a user or by the one or more computer processor 12. The selection of the structure 38 by the one or more computer processor 12 may be performed in a stand-alone operation or may be performed by the one or more computer processor 12 accessing a database of structures lacking interior structure information and selecting the structure 38 from the database to process. In one embodiment, the structure 38 is a dwelling, or house, while in other embodiments, the structure 38 is any building for which it is desired to classify the interior area of the building.

In one embodiment, the one or more computer processors 12 may execute the image analysis module 18 which may analyze one or more of the images 34 depicting external surfaces of the structure 38 in the captured image database 44 to estimate segmented classification maps 161 for the structure 38.

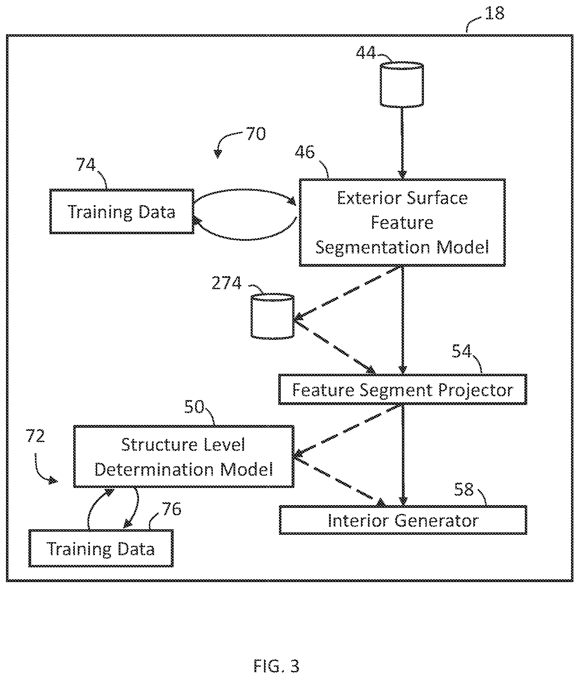

The image analysis module 18 may comprise an exterior surface feature segmentation model 46 implemented by a first artificial intelligence system 70 (see FIG. 3), a feature segment projector 54 (see FIG. 3), and an interior generator 58 (see FIG. 3). In some implementations, the image analysis module 18 may further comprise a structure level determination model 50 (see FIG. 3) implemented by a second artificial intelligence system 72. The first and second artificial intelligence systems 70, 72 may be, for example, one or more of a convolutional neural network, a generative adversarial network, a deep neural network, or any other machine learning system configured to implement a defined model. In some implementations, the image analysis module 18 may obtain the images 34 from, or receive the images 34 from, the captured image database 44. In some implementations, the image analysis module 18 may further comprise the captured image database 44.

In one embodiment, the report generation module 22 may be configured to generate a structure interior report 23. The structure interior report 23 may include one or more of total area, total living area, non-livable area, adjusted living area, building area, utility area, number of stories, number of garages, number of porches, and other information regarding the interior of the structure 38, for example. The structure interior report 23 may include one or more of the images 34. The structure interior report 23 may include one or more of the images 34 with one or more overlays indicative of interior area classifications. The overlays may include geometric shapes, shading, and/or colors. The structure interior report 23 may be in digital format, such as a pdf file or a display on one or more of the screens 296 of the user devices 284, and/or the structure interior report 23 may be in paper format. In some implementations, the structure interior report 23 may comprise data regarding interior information and may be utilized to create or update three-dimensional models of the structure 38 including interior and/or interior-use information.

Referring now to FIG. 3, shown therein is an example of the image analysis module 18 implemented with the computer system 11, including the first artificial intelligence system 70 structured to implement the exterior surface feature segmentation model 46. The first artificial intelligence system 70 may be in communication with, and/or may include, the captured image database 44 and training data 74. The first artificial intelligence system 70 may cause the one or more computer processors 12 to send the exterior surface feature segmentation model 46 one or more images 34, such as from the captured image database 44.

The exterior surface feature segmentation model 46 may cause the one or more computer processors 12 to segment the received images 34 into feature segments utilizing a machine learning model and may classify the feature segments with an interior area classification. The interior area classification may be stored in the one or more non-transitory memory 13 with the feature segment or such that the feature segment and its interior area classification are linked. The feature segments may then be returned or sent to the feature segment projector 54.

The exterior surface feature segmentation model 46 may be a machine learning model that has been trained using training data 74 to classify the feature segments with the interior area classifications. The training data 74 may include exterior images of a variety of structures 38 coupled with identifications of exterior parts of the structure 38 that are correlated with accurate building floorplan information. The exterior parts of the structures in the training data 74 may be correlated with interior floor plan information, such as classifications for the interiors of the structures 38. Nonexclusive examples of exterior parts of the structure 38 include a garage, a door, a window, a garage door, a porch, a balcony, an exterior wall, a roof, or the like. In some embodiments, a minimum labelled subset is anything that is covered with a roof or a roof-like material, such as a viable livable area, garage(s), and porch(es). Secondarily labeled data may include additional accoutrements such as doors, windows, decks, and the like.

In some implementations, identification of the exterior parts of the structures 38 shown in the exterior images 34 of the training data 74 can be accomplished manually, for example, by having human operator(s) labeling the exterior parts of the structures 38 depicted in the exterior images 34. In some implementations, correlation of the exterior parts of the structures 38 in the training data with interior floor plan information can be accomplished manually, for example, by having human operator(s) associating exterior parts of the structures 38 depicted in the exterior images 34 with interior area classifications. The training data 74 may be part of the image analysis module 18 or separate from the image analysis module 18. In some implementations, once the exterior surface feature segmentation model 46 is trained, the training data 74 may no longer be needed. In some implementations, after the exterior surface feature segmentation model 46 is initially trained, the exterior surface feature segmentation model 46 may be implemented without additional training data 74. In some implementations, the exterior surface feature segmentation model 46 is initially trained at a first time, and then updated with additional training data 74 at a second time, subsequent to the first time.

For example, the training data 74 may include training images showing a garage door or a garage. In this example, the garage door or garage is labeled within the training images, and provides an indication that the interior space adjacent to the garage door is a garage. The depth and/or width of the garage may be determined by the building floorplan information, as well as coupled with other indications on the exterior of the structure indicative of the depth and/or width of the garage. Such other indications may include location(s) of window(s) or the presence and/or absence of a door within a wall adjacent to the garage door as depicted in the one or more image 34.

Once the exterior surface feature segmentation model 46 is trained, the one or more computer processors 12 execute the exterior surface feature segmentation model 46 which cause the one or more computer processors 12 to analyze the digita images 34. For example, the exterior surface feature segmentation model 46 may determine that the exterior parts of the structure 38 depicted in the digital image 34 include the exterior feature of a garage door, and may segment the digital image 34 into a feature segment for a garage, based on that exterior feature. The exterior surface feature segmentation model 46 classifies the identified feature segments with an interior area classification. In this example, the exterior surface feature segmentation model 46 may classify the identified feature segments with an interior area classification of "garage area".

In some implementations, the exterior surface feature segmentation model 46 may classify one or more of the identified feature segments with an interior area classification of "livable" and/or "livable area". In some implementations, the exterior surface feature segmentation model 46 may classify one or more of the identified feature segments with an interior area classification of "non-livable" and/or "non-livable area".

In one embodiment, the exterior surface feature segmentation model 46 may receive an identification of a geographic area and then conduct feature segmentation on one or more images 34 corresponding to the structure 38 within the geographic area. The geographic area can be defined in a number of ways such as a street address or by a selection of at least three spatially disposed geographic coordinates. In some embodiments, a geo-coding provider may be used to translate location information (such as a street address) of the structure 38 into a set of coordinates, such as longitude-latitude coordinates. Next, the longitude-latitude coordinates (or other geographic coordinates) of the structure 38 may be used to query the image database 44 in order to retrieve one or more images 34 or one or more structure shapes of the structure 38.

Referring now to FIG. 4A, shown therein is an exemplary embodiment of an image 34a depicting the structure 38 from an oblique perspective, wherein the structure 38 has a first porch 80a, a second porch 80b, and a garage 84. While only the first porch 80a, the second porch 80b, and the garage 84 are shown in image 34a, it is understood that other structures may have additional identified features and that other objects may be depicted in the image 34a such as a road 88.

Referring now to FIG. 4B, shown therein is an exemplary embodiment of an image 34b depicting the structure 38, as also shown in the image 34a. The image 34b depicts the structure 38 from an orthogonal, also known as nadir, perspective. The image 34b also depicts the structure 38 having the first porch 80a, the second porch 80b, and the garage 84, and depicts the road 88.

While images 34a and 34b depict only the structure 38 and the road 88, other objects may also be depicted in the image such as vegetation, including but not limited to shrubbery, tall grass, trees, bushes, and flowers; geographic features, including but not limited to hills, cliffs, ponds, lakes, and rivers; and other human-made structures, including but not limited to sheds, pools, gardens, driveways, roads, bridges, sidewalks, and towers. It is understood that the drawings are limited to showing images 34a and 34b for simplicity, however, the number of images of the structure 38 may often exceed two images. In some implementations, the number of images 34 may include images 34 each side of the structure 38.

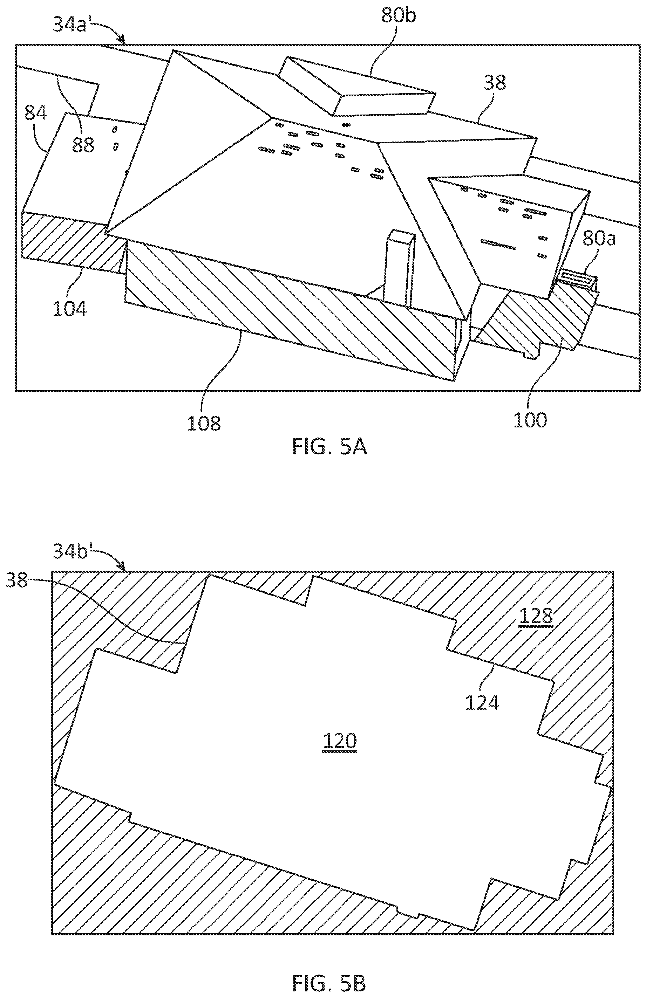

Referring now to FIGS. 5A and 5B, the exterior surface feature segmentation model 46 may segment the images 34a, 34b into feature segments, exemplary results of which are shown as segmented images 34a' and 34b' (referred to in general as segmented image(s) 34'). In the segmented image 34a', the exterior surface feature segmentation model has identified feature segments of the structure 38 including a first porch segment 100, a first garage segment 104, and a first living segment 108. The segmented image 34a' also depicts the structure 38 having the first porch 80a, the second porch 80b, and the garage 84 as well as the road 88. In some implementations, the segmented image 34a' may be generated by passing the image 34a to the exterior surface feature segmentation model 46 wherein the exterior surface feature segmentation model 46 identifies the feature segments in the image 34a. In some implementations, optionally, the feature segments may be shown in, or overlayed on, the segmented image 34'. The segmented image 34' and/or the feature segments may then be sent to the feature segment projector 54, described in detail below.

Shown in FIG. 5B is an exemplary embodiment of the segmented image 34b' in which the exterior surface feature segmentation model has identified feature segments of the structure 38 including a structure extent segment 120 indicative of the structure shape, a structure trace 124 encompassing or surrounding the structure extent segment 120 (such as an outline of the structure extent segment 120), and an exterior area 128 of a structure extent segment 120 (which may define areas depicted in the image 34 that are not part of the structure 38, for example).

In some implementations, the segmented image 34' may be a vector boundary of an outline describing the extent of the structure 38. In some implementations, the structure shape describes the portion of the structure 38 that consists only of a building (to the exclusion of a garden, a sidewalk, a driveway, an outdoor kitchen, a pool, etc., that may be co-located, adjacent to, or overlapping with the building). In some implementations, the structure shape may describe the portion of a structure 38 that includes a building and any adjacent features, such as a porch, driveway, patio, gazebo, pergola, awning, carport, shed, or any other feature that may be adjacent to the building. In some implementations, the feature(s) is attached to the building. For example, the feature can be an attached porch, awning or carport.

The segmented image 34b' may be generated by passing the image 34b to the exterior surface feature segmentation model 46 wherein the exterior surface feature segmentation model 46 identifies the feature segments in the image 34b. The segmented image 34b' may then be sent to the feature segment projector 54, described in detail below.

In some implementations, the exterior surface feature segmentation model 46 may store the segmented image(s) 34' and/or the segmented features in the segmented image database 274 (see FIG. 3).

In some implementations, the feature segment projector 54 may receive or obtain the segmented image(s) 34' and/or the segmented features from the segmented image database 274. In some implementations, the feature segment projector 54 may receive or obtain the segmented image(s) 34' and/or the segmented features from the exterior surface feature segmentation model 46.

In some embodiments, the structure shape and/or the structure trace 124 may be a series of edges and nodes defining a wireframe outline of the structure 38, two-dimensionally or three-dimensionally. In some embodiments, the structure shape and/or the structure trace 124 may be a structure outline.

In some implementations, the one or more computer processors 12 execute the feature segment projector 54 which causes the one or more computer processors 12 to project the structure trace 124 onto a coordinate system 140. In some implementations, the feature segment projector 54 may generate the coordinate system 140 before projecting the structure trace 124 onto the coordinate system 140. The feature segment projector 54 may create the coordinate system 140 and/or may define and/or receive the coordinate system by geographic coordinates, such as longitude, latitude, and altitude (which may be height above sea level or may be height above a ground surface or may be a level in a building such as a story of a building), and/or other geographic two-dimensional or three-dimensional grid. The feature segment projector 54 may project the one or more segmented images 34' (and/or the segment features) into the coordinate system 140 based on the geo-location data of the segmented image 34'.

In some implementations, the one or more computer processors 12 execute the feature segment projector 54 which causes the one or more computer processors 12 to execute the feature segment projector 54 which may create a structure model 130 utilizing the projected segment features and the coordinate system 140. The structure model 130 may be two-dimensional or three-dimensional. The structure model 130 may be a partial or complete depiction of the structure 38 based on the projected segment features and the coordinate system 140. The structure model 130 may include geographic coordinates of points or segment features based on the image metadata and/or the coordinate system 140.

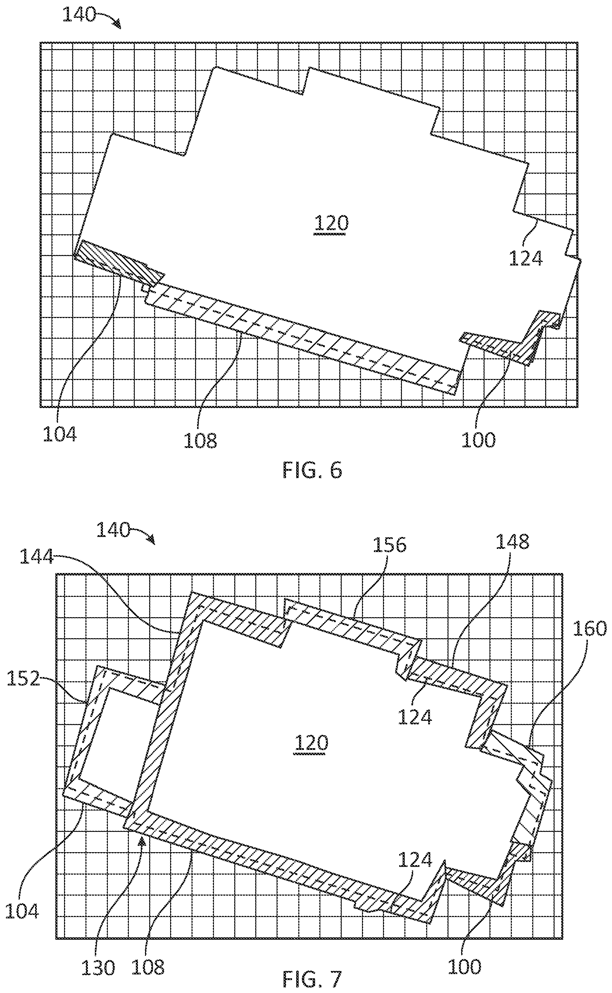

Referring now to FIG. 6, shown therein is an exemplary embodiment of the coordinate system 140 provided for the structure 38 having the first porch segment 100, the first garage segment 104, and the first living segment 108 of the segmented image 34a' and the structure extent segment 120 with the structure trace 124 of the segmented image 34b' projected thereon by the feature segment projector 54.

In one embodiment, the feature segment projector 54 may select the one or more segmented images 34' from the segmented image database 274. Selection of the one or more segmented images 34' for the structure 38 may be done by utilizing geographic location metadata stored in connection to the segmented image 34'. A plurality of segmented images 34' may be selected for projection that contain feature segments corresponding to a perimeter of the structure 38.

In one embodiment, the exterior surface feature segmentation model 46 and the feature segment projector 54 operate simultaneously such that after the exterior surface feature segmentation model 46 creates the segmented image 34a', the exterior feature segmentation model 46 creates the segmented image 34b' while the feature segment projector 54 projects the feature segments from segmented image 34a' into the coordinate system 140.

Shown in FIG. 7 is the coordinate system 140 of FIG. 6 further showing the feature segments after additional ones of the segmented images 34' have been projected onto the coordinate system 140. Additional feature segments from the additional ones of the segmented images 34' include in this example a second living segment 144, a third living segment 148, a second garage segment 152, a second porch segment 156, and a third porch segment 160.

Generally, once the feature segments are projected into the coordinate system 140, at least the structure trace 124 of the structure extent segment 120 has one or more feature segments overlaid in the coordinate system 140. For simplicity, only one layer of feature segments is shown in addition to the structure trace 124, however, more than one image 34 may have feature segments, that when projected into the coordinate system 140, may overlap one another. Additionally, each of the feature segments may have a height value based on the geo-location data from the image 34 and the segmented image 34'. When the coordinate system 140 is in three-dimensional space, the feature segments may be projected in three dimensions so as to include a height or altitude.

In some implementations, optionally, after the one or more images 34 of the structure 38 are segmented, and the one or more segmented images 34' are projected, the one or more computer processors 12 may execute the structure level determination model 50 which causes the one or more computer processors 12 to process the coordinate system 140 having the plurality of feature segments to determine the number of stories (also known as levels or floors) of the structure 38.

As shown in FIG. 3, the structure level determination model 50 may be implemented within the second artificial intelligence system 72. The structure level determination model 50 may utilize one or more machine learning algorithm. The structure level determination model may utilize a machine learning model that has been trained using training data 76 such as a training coordinate system having a plurality of feature segments and a level truth pairing, where the training coordinate system having a plurality of feature segments has been examined and the number of levels of the structure 38 has been previously, precisely determined. The training data 76 may be part of the image analysis module 18 and/or separate from the image analysis module 18.

In some implementations, once the structure level determination model 50 is trained, the training data 76 may no longer be needed. In some implementations, after the structure level determination model 50 is initially trained, the structure level determination model 50 may be implemented without additional training data. In some implementations, the structure level determination model 50 may be initially trained at a first time, and then updated with additional training data at a second time, subsequent to the first time.

A structure level determination may be made in order to determine the number of levels, or stories, of the structure 38 and may be used to provide an accurate determination of the interior square footage, interior living area, and other features or dimensions, of the structure 38, such as for multi-storied buildings. The one or more computer processors 12 may execute the structure level determination model 50 which may cause the one or more computer processors 12 to determine a number of stories of the structure 38. The structure level determination model 50 may update the structure model 130 to include the number of stories of the structure 38.

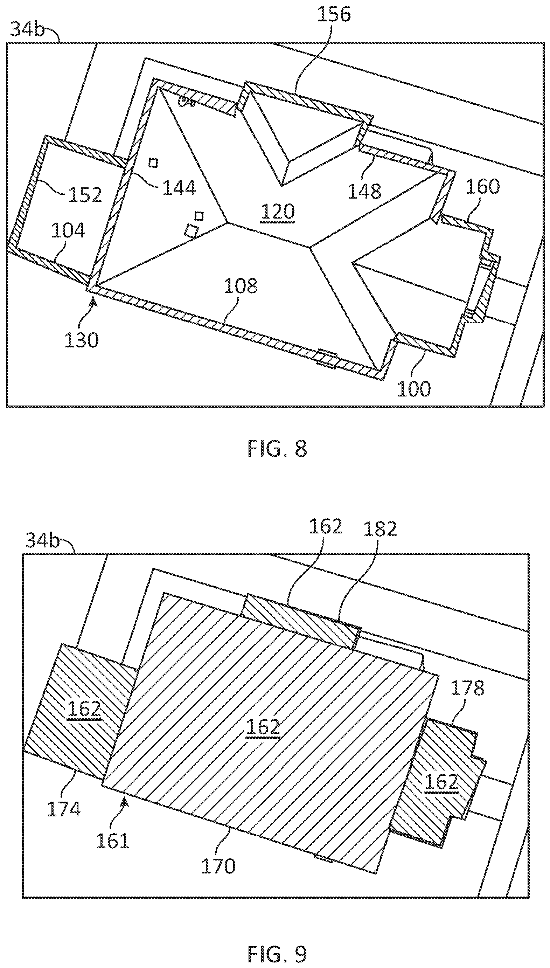

Referring now to FIGS. 8 and 9, in some implementations, the feature segments may be projected onto the original image 34 of the structure 38, with or without displaying the coordinate grid. FIG. 8 depicts the projection of the plurality of feature segments onto image 34b, the orthogonal image of structure 38. FIG. 8 depicts the plurality of feature segments projected onto image 34b showing only the portion of the feature segments that overlay the structure extent segment 120, the feature segments shown include the living segments 108, 144, and 148, the garage segments 104 and 152, and the porch segments 100, 156, and 160.

In some embodiments, one or more of the plurality of feature segments is not projected back onto the image 34. In some embodiments, however, the portion of each the plurality of feature segments that do not intersect with the structure extent segment 120 may be removed.

In some implementations, as shown in FIG. 3, the one or more computer processors 12 may execute the interior generator 58 which causes the one or more computer processors 12 to generate the segmented classification map 161 composed of floor segments 162. The floor segment(s) 162 corresponds to a feature segment of a specific interior area classification. The exterior perimeter of the floor segment 162 may be limited by, and/or defined by, the corresponding feature segment(s).

In some implementations, the interior generator 58 may generate the segmented classification map 161 by fitting one or more geometric section indicative of the floor segments 162 into the structure model 130 in a position and orientation based at least in part on a plurality of exterior feature segments.

For example, shown in FIG. 9 is an exemplary segmented classification map 161 shown as overlaid on the image 34b. The segmented classification map 161 comprises geometric figures generated by the interior generator 58, the geometric figures indicative of the floor segments 162. In this example, the floor segments 162 include a living area 170, a garage area 174, a first porch area 178, and a second porch area 182 of the structure 38.

The segmented classification map 161 may be formed of geometric figures such that edges of a floor segment 162 align to feature segments of the same type. For example, as shown in FIGS. 8 and 9, the living area 170 of the floor segments 162 is bound by the living segments 108, 144, and 148 of the feature segments, the garage area 174 is bounded by the garage segments 104 and 152 of the feature segments, the first porch area 178 is bound by the first porch feature segment 100 and the third porch feature segment 160, and the second porch area 182 is bound by the second porch feature segment 156. The projection of the geometric figures indicative of the floor segments 162 onto image 34b in the form of the segmented classification map 161 may further include level data and/or height data such that two or more geometric figures may be disposed one atop another based on the level (or story) of the structure 38.

In some embodiments, the geometric figures can be overlaid onto the image 34 as one or more layers. In some embodiments, the generation of geometric figures indicative of the floor segments 162 by the interior generator 58 may be performed in the coordinate system 140 such that the geometric figures are not projected onto the image 34.

In some embodiments, the report generation module 22 may generate the structure interior report 23 which may comprise interior area square footage of different interior area classifications and/or other available information about the interior features of the structure 38. For example, the report generation module 22 may generate the structure interior report 23 including the total square footage of the structure 38, the total living area of the structure 38, the non-livable area of the structure 38, the adjusted living area of the structure 38, the building area of the structure 38, the utility area of the structure 38, the garage area of the structure 38, the porch area of the structure 38, the structure model, one or more of the digital images 34, and/or the number of levels in the structure 38.

The total square footage of the structure 38 may be calculated by summing the square footage of each of the floor segments. The livable area of the structure 38 may be calculated by summing the square footage of the floor segments 162 classified as the living area 170. The non-livable area of the structure 38 may be calculated by summing the square footage of the floor segments 162 classified in categories defined as non-livable, such as the garage area 174, the first porch area 178, and the second porch area 182, for example. The garage area of the structure 38 may be calculated by summing the square footage of the floor segments 162 classified as the garage area 174. The total porch area may be calculated by summing the square footage of the floor segments 162 classified as the first porch area 178 and the second porch area 182, for example.

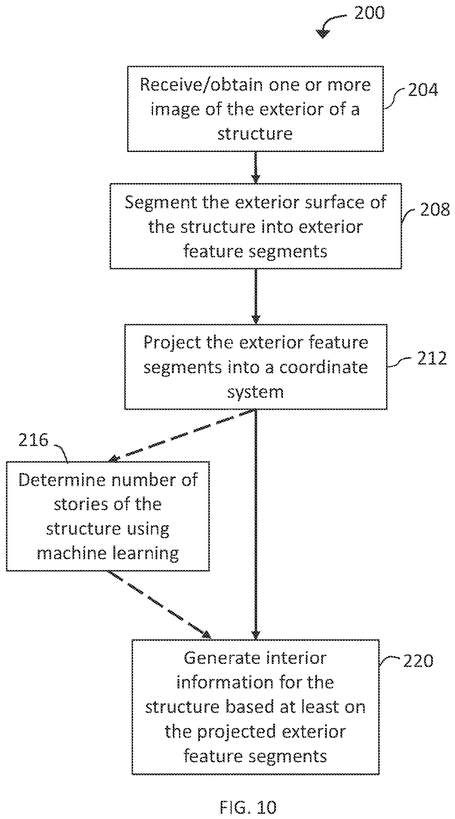

FIG. 10 is process flow diagram of an exemplary embodiment of an interior area classification method 200 in accordance with the present disclosure. The interior area classification method 200 generally may include receiving or obtaining, with the one or more computer processors 12, the one or more digital image 34 of the exterior of the structure 38 (step 204); segmenting the exterior surfaces of the structure 38 in the corresponding one of the one or more images 34 into a plurality of exterior feature segments using machine learning with the one or more computer processors 12 (step 208); projecting, with the one or more computer processors 12, the plurality of exterior feature segments into the coordinate system 140 (step 212); optionally, determining the number of stories of the structure 38, such as by using machine learning techniques, with the one or more computer processors 12 (step 216); and, generating internal structure information for the structure 38 (step 220). The interior area classification method 200 may further comprise generating the structure interior report 23, with the one or more computer processors 12.

In step 204, the one or more computer processors 12 may obtain or receive the one or more digital images 34 of the exterior of the structure 38 from the image database 44 and/or from the image capture system 14. In some embodiments, the one or more digital images 34 may comprise two or more digital images 34, one of which being an oblique image captured from an oblique viewpoint.

In step 208, the one or more computer processors 12 may execute the exterior surface feature segmentation model 46 which may cause the one or more computer processors 12 to segment the exterior surface of the structure 38 in the one or more digital images 34 into exterior feature segments. The exterior surface feature segmentation model 46 may utilize machine learning to recognize exterior parts of the structure 38 and classify the exterior parts as the exterior feature segments indicative of interior areas of the structure 38. In addition to the feature segments, the exterior surface feature segmentation model 46 may generate one or more segmented images 34'.

In step 212, the one or more computer processors 12 may execute the feature segment projector 54 which cause the one or more computer processors 12 to project the feature segments into the coordinate system 140 by using the geo-location metadata associated with the one or more digital images 34. The latitude-longitude-altitude data associated with a pixel in the image 34 is used to project the feature segment that was originated with that pixel into the coordinate system 140 at a matching or corresponding coordinate in the coordinate system 140. The feature segment projector 54 generates the coordinate system 140.

In optional step 216, the one or more computer processors 12 may execute the structure level determination model 50, which may cause the one or more computer processors 12 to determine the number of stories of the structure 38, such as by using machine learning techniques described above. The determination of the number of stories of the structure 38 may be unnecessary if the number of stories is provided or if the number of stories is assumed to be one.

In step 220, the one or more computer processors 12 execute the interior generator 58 which cause the one or more computer processors 12 to generating internal structure information for the structure 38. The one or more computer processors 12 execute the interior generator 58 which causes the one or more computer processors 12 to generate the segmented classification map 161 composed of floor segments 162. The floor segment(s) 162 correspond to a feature segment of a specific interior area classification. The exterior perimeter of the floor segment 162 may be limited by, and/or defined by, the corresponding feature segment(s). In some implementations, the interior generator 58 may generate the segmented classification map 161 by fitting one or more geometric section indicative of the floor segments 162 into the structure model 130 in a position and orientation based at least in part on a plurality of exterior feature segments. In some implementations, the interior generator 58 may overlay the floor segments 162 from the segmented classification map 161 over the one or more digital image 34. The floor segments 162 may be shown as colored, textured, and/or semitransparent geometric shapes overlaid on the depiction of the structure 38 in the one or more digital images 34.

In some implementations, the interior area classification method 200 may further comprise the one or more computer processors 12 executing the report generation module 22 which may cause the one or more computer processors 12 to generate a structure interior report 23 including information about the interior of the structure 38. The structure interior report 23 may include one or more of total area, total living area, non-livable area, adjusted living area, building area, utility area, number of stories, number of garages, number of porches, and other information regarding the interior of the structure 38, for example. The structure interior report 23 may include one or more of the images 34. The structure interior report 23 may include one or more of the images 34 with one or more overlays indicative of interior area classifications. The overlays may include geometric shapes, shading, and/or colors.

From the above description and examples, it is clear that the inventive concepts disclosed and claimed herein are well adapted to attain the advantages mentioned herein.

The results of the interior area classification method 200 and system 10 may be used for a wide variety of real-world applications with respect to the structure 38. Non-exclusive examples of such applications include use of the results to determine a tax assessment, provide and/or complete inspections, to evaluate condition, to repair, to create under-writing, to insure, to purchase, to construct, or to value the structure 38.

It is to be understood that the steps disclosed herein may be performed simultaneously or in any desired order. For example, one or more of the steps disclosed herein may be omitted, one or more steps may be further divided in one or more sub-steps, and two or more steps or sub-steps may be combined in a single step, for example. Further, in some exemplary embodiments, one or more steps may be repeated one or more times, whether such repetition is carried out sequentially or interspersed by other steps or sub-steps. Additionally, one or more other steps or sub-steps may be carried out before, after, or between the steps disclosed herein, for example.

## Claims

1. A non-transitory computer readable medium storing computer executable code that when executed by one or more computer processors (12) causes the one or more computer processors to:
receive (204) one or more digital images (34) depicting an exterior surface of a structure (38) having a plurality of exterior features, each of the exterior features having one or more feature classifications of an interior of the structure, each of the one or more digital images having geographic image metadata including a determined geo-location comprising X, Y, and Z coordinates and/or latitude, longitude, and elevation / altitude coordinates for pixels in the one or more digital images;
process (208) the exterior surface depicted in each of the one or more digital images into a plurality of exterior feature segments and classify each of the exterior feature segments with an interior area classification with an exterior surface feature classifier model or a surface feature segmentation model, each of the exterior feature segments corresponding to at least one exterior feature;
project (212) each of the plurality of exterior feature segments into a coordinate system at a matching or corresponding coordinate in the coordinate system using the determined geo-location of the geographic image metadata originated with the pixel, the projected exterior feature segments forming a structure model; and
generate (220) a segmented classification map (161) of the interior of the structure by fitting one or more geometric sections as floor segments (162) indicative of interior feature segments corresponding to the interior area classifications of the exterior feature segments of the structure into the structure model in a position and orientation based at least in part on the plurality of exterior feature segments.

2. The non-transitory computer readable medium of claim 1, wherein the computer executable code when executed by the one or more computer processors further cause the one or more computer processors to process (216) the exterior surface depicted in the one or more digital images to determine a number of stories of the structure; and update the structure model to include the number of stories.

3. The non-transitory computer readable medium of claim 1, wherein the feature classifications comprise livable and non-livable.

4. The non-transitory computer readable medium of claim 3, wherein the livable feature classification comprises a utility classification.

5. The non-transitory computer readable medium of claim 3, wherein each of the one or more geometric sections has a length, a width, and an area, and wherein the computer executable code when executed by the one or more computer processors further cause the one or more computer processors to:
calculate a living area of the interior by summing the area of each of the one or more geometric sections corresponding to exterior features with at least one feature classification of livable.

6. The non-transitory computer readable medium of claim 1, wherein the exterior features include one or more of a roof, a wall, a porch, a garage, a garage door, a carport, a deck, and a patio.

7. The non-transitory computer readable medium of claim 1, wherein the image metadata includes geographic-location, orientation, and camera parameters of a camera (30) at a moment each digital image is captured.

8. The non-transitory computer readable medium of claim 1, wherein the computer executable code when executed by the one or more computer processors further cause the one or more computer processors to:
generate an interior report (23) comprising interior area square footage of at least two different interior area classifications.

9. The non-transitory computer readable medium of claim 8, wherein the two different interior area classifications include a total square footage of the structure, and a total livable area of the structure.

10. The non-transitory computer readable medium of claim 1, wherein the computer executable code when executed by the one or more computer processors further cause the one or more computer processors to:
overlay the segmented classification map of the interior of the structure on the one or more digital images.

11. The non-transitory computer readable medium of any one of claims 1 to 10 wherein processing the exterior surface depicted in each of the one or more digital images into the plurality of exterior feature segments includes analyzing pixels of a first digital image and a second digital image depicting an exterior surface of a first structure to determine exterior feature segments indicative of one or more interior areas of the first structure, utilizing a first artificial intelligence system (70) trained with exterior images of a plurality of second structures coupled with identifications of exterior parts of the second structures that are correlated with interior floor plan information, the first digital image and the second digital image being captured from different viewpoints of the first structure.

12. The non-transitory computer readable medium of claim 11, wherein the computer executable code when executed by the one or more computer processors cause the one or more computer processors to:
process, with a structure level determination model (50) implemented by a second artificial intelligence system (72), the exterior surface depicted in at least one of the first digital image and the second digital image to determine a number of stories of the first structure; and
update the structure model to include the number of stories.

13. The non-transitory computer readable medium of claim 11, wherein the geographic image metadata is associated with one or both of the first digital image and the second digital image and includes location, orientation, and camera parameters of a camera (30) at a moment each image is captured.

14. The non-transitory computer readable medium of any one of claims 1 to 13, wherein the computer executable code when executed by the one or more computer processors cause the one or more computer processors to create a structure model (130) utilizing the projected exterior feature segments and the coordinate system.

## Patentansprüche

1. Nichtflüchtiges, computerlesbares Medium, das einen computerausführbaren Code speichert, der, wenn er von einen oder mehreren Computerprozessoren (12) ausgeführt wird, ferner den einen oder die mehreren Computerprozessoren dazu veranlasst, um:
ein oder mehrere digitale Bilder (34) zu empfangen (204), die eine Außenfläche einer Struktur (38) mit einer Vielzahl von Außenmerkmalen darstellen, wobei jedes der Außenmerkmale eine oder mehrere Merkmalsklassifizierungen eines Innenraums der Struktur aufweist, wobei jedes des einen oder der mehreren digitalen Bilder geografische Bildmetadaten einschließlich einer bestimmten Geolokalisierung aufweist, die X-, Y- und Z-Koordinaten und/oder Breiten-, Längen- und Erhöhungs-/Höhenkoordinaten für Pixel in dem einen oder den mehreren digitalen Bildern umfasst;
die in jedem des einen oder der mehreren digitalen Bilder dargestellte Außenfläche in eine Vielzahl von Außenmerkmalsegmenten zu verarbeiten und jedes der Außenmerkmalsegmente mit einer Innenraumflächenklassifizierung mit einem Außenflächenmerkmal-Klassifizierungsmodell oder einem Flächenmerkmal-Segmentierungsmodell zu klassifizieren, wobei jedes der Außenmerkmalsegmente mindestens einem Außenmerkmal entspricht;
jedes der Vielzahl von Außenmerkmalsegmenten in ein Koordinatensystem an einer passenden oder entsprechenden Koordinate in dem Koordinatensystem unter Verwendung der bestimmten Geolokalisierung der geografischen Bildmetadaten, die mit dem Pixel entstanden sind, zu projizieren (212), wobei die projizierten Außenmerkmalsegmente ein Strukturmodell bilden; und
eine segmentierten Klassifizierungskarte (161) des Innenraums der Struktur durch Einpassen eines oder mehrerer geometrischer Abschnitte als Bodensegmente (162) zu erzeugen (220), die Innenraummerkmalsegmente anzeigen, die den Innenraumflächenklassifizierungen der Außenmerkmalsegmente der Struktur entsprechen, in das Strukturmodell in einer Position und Ausrichtung, die zumindest teilweise auf der Vielzahl von Außenmerkmalsegmenten basiert.

2. Nichtflüchtiges, computerlesbares Medium nach Anspruch 1, wobei der computerausführbare Code, wenn er von dem einen oder den mehreren Computerprozessoren ausgeführt wird, ferner den einen oder die mehreren Computerprozessoren dazu veranlasst, die in dem einen oder den mehreren digitalen Bildern dargestellte Außenfläche zu verarbeiten (216), um die Anzahl der Stockwerke des Bauwerks zu bestimmen; und das Bauwerksmodell zu aktualisieren, um die Anzahl der Stockwerke einzubeziehen.

3. Nichtflüchtiges, computerlesbares Medium nach Anspruch 1, wobei die Merkmalsklassifizierungen bewohnbar und nicht bewohnbar umfassen.

4. Nichtflüchtiges, computerlesbares Medium nach Anspruch 3, wobei die bewohnbare Klassifizierung eine Nutzungsklassifizierung umfasst.

5. Nichtflüchtiges, computerlesbares Medium nach Anspruch 3, wobei jeder des einen oder der mehreren geometrischen Abschnitte eine Länge, eine Breite und eine Fläche aufweist und wobei der computerausführbare Code, wenn er von dem einen oder den mehreren Computerprozessoren ausgeführt wird, den einen oder die mehreren Computerprozessoren ferner dazu veranlasst:
die Wohnfläche des Innenraums zu berechnen, indem die Fläche jedes einzelnen oder der mehreren geometrischer Abschnitte addiert werden, die Außenmerkmalen entsprechen, wobei mindestens eine Merkmalsklassifizierung bewohnbar ist.

6. Nichtflüchtiges, computerlesbares Medium nach Anspruch 1, wobei die Außenmerkmale eines oder mehrere der folgenden Elemente umfassen: ein Dach, eine Wand, eine Veranda, eine Garage, ein Garagentor, einen Carport, eine Terrasse und einen Innenhof.

7. Nichtflüchtiges, computerlesbares Medium nach Anspruch 1, wobei die Bildmetadaten geografische Standort-, Ausrichtungs- und Kameraparameter einer Kamera (30) zu dem Zeitpunkt umfassen, in dem jedes digitale Bild aufgenommen wird.

8. Nichtflüchtiges, computerlesbares Medium nach Anspruch 1, wobei der computerausführbare Code, wenn er von dem einen oder den mehreren Computerprozessoren ausgeführt wird, ferner den einen oder die mehreren Computerprozessoren dazu veranlasst:
einen Innenraumbericht (23) zu erzeugen, der die innere Flächenquadratmeterzahl von mindestens zwei verschiedenen Innenraumflächenklassifizierungen enthält.

9. Nichtflüchtiges, computerlesbares Medium nach Anspruch 8, wobei die beiden verschiedenen Innenraumflächenklassifizierungen die Gesamtquadratmeterzahl der Struktur und die gesamte bewohnbare Fläche der Struktur umfassen.

10. Nichtflüchtiges, computerlesbares Medium nach Anspruch 1, wobei der computerausführbare Code, wenn er von dem einen oder den mehreren Computerprozessoren ausgeführt wird, den einen oder die mehreren Computerprozessoren ferner dazu veranlasst:
die segmentierte Klassifizierungskarte des Innenraums der Struktur auf das eine oder die mehreren digitalen Bilder zu überlagern.

11. Nichtflüchtiges, computerlesbares Medium nach einem der Ansprüche 1 bis 10, wobei das Verarbeiten der in jedem der einen oder mehreren digitalen Bilder dargestellten Außenfläche in die Vielzahl von Außenmerkmalsegmenten das Analysieren von Pixeln eines ersten digitalen Bildes und eines zweiten digitalen Bildes umfasst, die eine Außenfläche einer ersten Struktur darstellen, um Außenmerkmalsegmente zu bestimmen, die eine oder mehrere Innenflächen der ersten Struktur anzeigen, unter Verwendung eines ersten künstlichen Intelligenzsystems (70) umfasst, das mit Außenbildern einer Vielzahl von zweiten Strukturen in Verbindung mit Identifizierungen von Außenteilen der zweiten Strukturen, die mit Innenraumplaninformationen korrelieren, trainiert wurde, wobei das erste digitale Bild und das zweite digitale Bild aus verschiedenen Blickwinkeln der ersten Struktur aufgenommen wurden.

12. Nichtflüchtiges, computerlesbares Medium nach Anspruch 11, wobei der computerausführbare Code, wenn er von dem einen oder den mehreren Computerprozessoren ausgeführt wird, den einen oder die mehreren Computerprozessoren dazu veranlasst:
mit einem Strukturbestimmungsmodell (50), das von einem zweiten künstlichen Intelligenzsystem (72) implementiert wird, die in mindestens einem des ersten digitalen Bildes und des zweiten digitalen Bildes dargestellte Außenfläche zu verarbeiten, um eine Anzahl von Stockwerken der ersten Struktur zu bestimmen; und
das Strukturmodell zu aktualisieren, um die Anzahl der Stockwerke einzubeziehen.

13. Nichtflüchtiges, computerlesbares Medium nach Anspruch 11, wobei die geografischen Bildmetadaten dem einen oder beiden des ersten digitalen Bildes und des zweiten digitalen Bildes zugeordnet sind und Standort-, Ausrichtungs- und Kameraparameter einer Kamera (30) zum Zeitpunkt der Aufnahme jedes Bildes umfassen.

14. Nichtflüchtiges, computerlesbares Medium nach einem der Ansprüche 1 bis 13, wobei der computerausführbare Code, wenn er von dem einen oder den mehreren Computerprozessoren ausgeführt wird, den einen oder die mehreren Computerprozessoren veranlasst, ein Strukturmodell (130) unter Verwendung der projizierten Außenmerkmalsabschnitte des Koordinatensystems zu erstellen.

## Revendications

1. Support lisible par ordinateur non transitoire stockant un code exécutable par ordinateur qui, lorsqu'il est exécuté par un ou plusieurs processeurs d'ordinateur (12), amène l'un ou les processeurs d'ordinateur à :
recevoir (204) une ou plusieurs images numériques (34) représentant une surface extérieure d'une structure (38) ayant une pluralité caractéristiques extérieures, chacune des caractéristiques extérieures ayant une ou plusieurs classifications de caractéristiques d'un intérieur de la structure, chacune de l'une ou des plusieurs images numériques ayant des métadonnées d'image géographique comprenant une géolocalisation déterminée comprenant les coordonnées X, Y et Z et/ou la latitude, la longitude et les coordonnées d'élévation/altitude pour les pixels dans l'une ou les plusieurs images numériques ;
traiter (208) la surface extérieure représentée dans chacune de l'une ou des plusieurs images numériques en une pluralité de segments de caractéristiques extérieures et classer chacun des segments de caractéristiques extérieures avec une classification de zone intérieure à l'aide d'un modèle de classification de caractéristiques de surface extérieure ou d'un modèle de segmentation de caractéristiques de surface, chacun des segments de caractéristiques extérieures correspondant à au moins une caractéristique extérieure ;
projeter (212) chacun de la pluralité de segments de caractéristiques extérieures dans un système de coordonnées à une coordonnée équivalente ou correspondante dans le système de coordonnées en utilisant la géolocalisation déterminée des métadonnées d'image géographique provenant du pixel, les segments de caractéristiques extérieures projetés formant un modèle de structure ; et
générer (220) une carte de classification segmentée (161) de l'intérieur de la structure en adaptant une ou plusieurs sections géométriques en tant que segments de sol (162) indiquant des segments de caractéristiques intérieures correspondant aux classifications de la zone intérieure des segments de caractéristiques extérieures de la structure dans le modèle de structure dans une position et une orientation basées au moins en partie sur la pluralité de segments de caractéristiques extérieures.

2. Support lisible par ordinateur non transitoire selon la revendication 1, dans lequel le code exécutable par ordinateur, lorsqu'il est exécuté par l'un ou les plusieurs processeurs informatiques amène en outre l'un ou les plusieurs processeurs informatiques à traiter (216) la surface extérieure représentée dans une ou plusieurs images numériques afin de déterminer le nombre d'étages de la structure ; et mettre à jour le modèle de structure pour inclure le nombre d'étages.

3. Support lisible par ordinateur non transitoire selon la revendication 1, dans lequel les classifications des caractéristiques comprennent l'habitabilité et la non habitabilité.

4. Support lisible par ordinateur non transitoire selon la revendication 3, dans lequel la classification des caractéristiques habitables comprend une classification d'utilité.

5. Support lisible par ordinateur non transitoire selon la revendication 3, dans lequel chacune de l'une ou des plusieurs sections géométriques a une longueur, une largeur et une surface, et dans lequel le code exécutable par ordinateur, lorsqu'il est exécuté par l'un ou les plusieurs processeurs informatiques, amène en outre l'un ou les plusieurs processeurs informatiques à :
calculer une surface habitable de l'intérieur en additionnant la surface de chacune de l'une ou des plusieurs sections géométriques correspondant aux caractéristiques extérieures avec au moins une classification de caractéristique habitable.

6. Support lisible par ordinateur non transitoire selon la revendication 1, dans lequel les caractéristiques extérieures comprennent un ou plusieurs parmi un toit, mur, porche, garage, porte de garage, abri pour voiture, terrasse et patio.

7. Support lisible par ordinateur non transitoire selon la revendication 1, dans lequel les métadonnées d'image comprennent l'emplacement géographique, l'orientation et les paramètres d'appareil photo de l'appareil photo (30) à un moment où chaque image numérique est capturée.

8. Support lisible par ordinateur non transitoire selon la revendication 1, dans lequel le code exécutable par ordinateur, lorsqu'il est exécuté par l'un ou les plusieurs processeurs informatiques amène en outre l'un ou les plusieurs processeurs informatiques à :
générer un rapport sur l'intérieur (23) comprenant la superficie en pieds carrés d'une surface intérieure d'au moins deux classifications de surface intérieure différentes.

9. Support lisible par ordinateur non transitoire selon la revendication 8, dans lequel les deux classifications de surface intérieure différentes comprennent une superficie en pieds carrés totale de la structure et une surface habitable totale de la structure.

10. Support lisible par ordinateur non transitoire selon la revendication 1, dans lequel le code exécutable par ordinateur, lorsqu'il est exécuté par l'un ou les plusieurs processeurs informatiques, amène en outre l'un ou les plusieurs processeurs informatiques à :
superposer la carte de classification segmentée de l'intérieur de la structure sur l'une ou les plusieurs images numériques.

11. Support lisible par ordinateur non transitoire selon l'une quelconque des revendications 1 à 10 dans lequel le traitement de la surface extérieure représentée dans chacune de l'une ou des plusieurs images numériques dans la pluralité de segments de caractéristiques extérieures comprend l'analyse des pixels d'une première image numérique et d'une seconde image numérique représentant une surface extérieure d'une première structure pour déterminer les segments de caractéristiques extérieures indiquant une ou plusieurs zones intérieures de la première structure, l'utilisation d'un premier système d'intelligence artificielle (70) entraîné avec des images extérieures d'une pluralité de secondes structures associées à des identifications de parties extérieures des secondes structures qui sont corrélées avec des informations de plan d'étage intérieur, la première image numérique et la seconde image numérique étant capturées à partir de différents points de vue de la première structure.

12. Support lisible par ordinateur non transitoire selon la revendication 11, dans lequel le code exécutable par ordinateur, lorsqu'il est exécuté par l'un ou les plusieurs processeurs informatiques, amène l'un ou les plusieurs processeurs informatiques à :
traiter, à l'aide d'un modèle de détermination de niveau de structure (50) mis en œuvre par un second système d'intelligence artificielle (72), la surface extérieure représentée dans au moins l'un parmi la première image numérique et la seconde image numérique pour déterminer le nombre d'étages de la première structure ; et
mettre à jour le modèle de structure pour inclure le nombre d'étages.

13. Support lisible par ordinateur non transitoire selon la revendication 11, dans lequel les métadonnées d'image géographique sont associées à l'une ou aux deux de la première image numérique et la seconde image numérique et comprennent l'emplacement, l'orientation et les paramètres d'appareil photo de l'appareil photo (30) à un moment où chaque image est capturée.

14. Support lisible par ordinateur non transitoire selon l'une quelconque des revendications 1 à 13, dans lequel le code exécutable par ordinateur, lorsqu'il est exécuté par l'un ou les plusieurs processeurs informatiques, amène l'un ou les plusieurs processeurs informatiques à créer un modèle de structure (130) en utilisant les segments de caractéristiques extérieures projetés et le système de coordonnées.
